# EUROPEAN PATENT APPLICATION

(11) **EP 4 582 602 A1**
(43) Date of publication of application: **09.07.2025**
(21) Application number: 24786345.9
(22) Date of filing: 12.06.2024
(51) Int. Cl.: C30B 29/40, H01L 21/304, H01L 21/306

(54) **INDIUM PHOSPHIDE SUBSTRATE AND SEMICONDUCTOR EPITAXIAL WAFER**

(30) Priority: 13.11.2023 JP 2023193169
(71) Applicant: JX Advanced Metals Corporation, Tokyo 105-8417 (JP)
(72) Inventor: OKA, Shunsuke, Kitaibaraki-shi, Ibaraki 3191535 (JP); YAMAGISHI, Kodai, Kitaibaraki-shi, Ibaraki 3191535 (JP); SUZUKI, Kenji, Kitaibaraki-shi, Ibaraki 3191535 (JP)
(74) Representative: Yeadon IP Limited
(86) International application number: PCT/JP2024/021401
(87) International publication number: WO 2025/104950

(57) **Abstract**

An indium phosphide substrate, wherein a diameter is 50 mm or more, and a waviness Wz of the entire substrate surface excluding the edge portion is 800 nm or less.

## Description

### FIELD OF THE INVENTION

The present invention relates to an indium phosphide substrate and a semiconductor epitaxial wafer.

### BACKGROUND OF THE INVENTION

Indium phosphide (InP) is a III-V group compound semiconductor material consisting of indium (In) of group III and phosphorus (P) of group V. Its characteristics as a semiconductor material are a band gap of 1.35 eV, an electron mobility of up to 5400 cm2/V·s, and its electron mobility under a high electric field is higher than that of other general semiconductor materials such as silicon and gallium arsenide. InP also has a stable crystal structure at room temperature and pressure, which is a cubic zinc blende structure, and its lattice constant is larger than that of compound semiconductors such as gallium arsenide (GaAs) and gallium phosphide (GaP).

In silicon photonics, a method is used in which epitaxial growth is performed on an InP substrate, and then the InP epitaxial growth layer is bonded to a Si substrate to form a device. In the bonding process, adhesion between the InP epitaxial growth layer and the Si device is extremely important for the device characteristics, and waviness on the substrate surface are also propagated to the film surface after epitaxial growth, and are thought to be related to the bonding accuracy. Thus, it is very important to control the waviness on the surface of the InP epitaxial growth layer when bonding it to the Si device.

Patent Literature 1 discloses a technique for suppressing surface waviness of an InP wafer by performing mirror polishing on a rotating polishing disk equipped with an abrasive cloth using a predetermined InP wafer mirror polishing liquid.

Patent Literature 2 discloses a technique for grinding semiconductor wafers, which is characterized in that a semiconductor wafer is chucked onto the surface of a plurality of disk-shaped chucks rotatably arranged on a circumference, a disk-shaped grindstone having at least the size of the circumference is rotated in the opposite direction to the rotation direction of the chuck, and water and then a drying gas are sprayed from a nozzle provided in the center of the grindstone to grind the semiconductor wafers, and the chuck and the grindstone are brought relatively close to each other in the direction of the rotation axis to keep the contact area between the wafer and the grindstone constant, and the plurality of wafers are ground together to a predetermined thickness. In this technique, the chuck and the grindstone are brought relatively close to each other in the direction of the rotation axis to bring them into contact with each other, water and then a drying gas are sprayed from the nozzle, and the grindstone grinds the surfaces of the plurality of wafers together to a predetermined thickness, thereby suppressing waviness of the substrate.

Patent Literature 3 discloses a method for polishing indium phosphide, which is characterized by using a mixed solution of a solution in which bromine is dissolved in methyl alcohol and an aqueous solution of silica colloid. By polishing the substrate by adjusting the mixed solution in this way, waviness of the substrate caused by etch pits is suppressed.

### CITATION LIST

### Patent Literatures

[Patent Literature 1] Japanese Examined Patent Application Publication No. 07-027881
[Patent Literature 2] Japanese Patent No. 3316939
[Patent Literature 3] Japanese Unexamined Patent Application Publication No. Sho 58-145604

### SUMMARY OF THE INVENTION

As mentioned above, when epitaxial growth is performed on an InP substrate and then bonded to a Si substrate to form a device, the adhesion between the InP epitaxial growth layer and the Si device is extremely important for the device characteristics, but the waviness of the substrate surface is also propagated to the film surface after epitaxial growth, and is thought to be related to the bonding accuracy. Therefore, when epitaxial growth is performed using an InP substrate with a large waviness over the entire surface, there is a problem that bonding does not go well.

The techniques disclosed in Patent Literatures 1 and 2 are intended to suppress waviness in a substrate, but there is no disclosure as to the extent to which waviness is suppressed over the entire substrate.

Furthermore, the technology disclosed in Patent Literature 3 suppresses waviness of a substrate caused by etch pits, and focuses on local waviness of the substrate to suppress the local waviness. Thus, Patent Document 3 does not disclose a technology for suppressing waviness over the entire substrate.

The present invention has been made to solve the above-mentioned problems, and has an object to provide an indium phosphide substrate and a semiconductor epitaxial wafer with suppressed surface waviness.

The above problems are solved by the present invention, which is specified as follows.
1. An indium phosphide substrate, wherein
   a diameter is 50 mm or more, and a waviness Wz of the entire substrate surface excluding the edge portion is 800 nm or less, and
   the waviness Wz of the entire substrate surface excluding the edge portion is measured by the following steps (1) to (2):
      (1) for an indium phosphide substrate, the area within 5 mm from the outer periphery to the center is defined as the edge portion, and the entire wafer surface excluding the area within 5 mm from the outer periphery to the center is defined as "the entire substrate surface excluding the edge portion",
      (2) next, the waviness Wz is measured using a white light interference measurement function of a laser microscope. In the measurement, a 10x lens for interference measurement is used to measure the waviness curve in a range of 1 mm x 40 mm with the center of the wafer being the center of the measurement range, and the waviness is calculated with a cutoff wavelength λc = 25 mm. In calculating the waviness Wz, the center of the short side direction on the substrate surface in a range of 1 mm x 40 mm is used as a reference line, and 20 lines with an interval of 4.5 µm are used as one measurement interval, and the waviness over 40 mm in the long side direction of 11 lines, including 10 surrounding lines moved parallel to the short side direction for the reference line and the reference line, is calculated, and the average value is used as the waviness Wz.
2. The indium phosphide substrate according to 1, wherein
   the waviness Wz of the entire substrate surface excluding the edge portion is 500 to 800 nm.
3. The indium phosphide substrate according to 1 or 2, wherein
   the diameter is 50 to 150 mm.
4. A semiconductor epitaxial wafer, comprising:
   the indium phosphide substrate according to any one of 1 to 3, and
   an epitaxial crystal layer provided on the main surface of the indium phosphide substrate.

According to the embodiments of the present invention, it is possible to provide an indium phosphide substrate and a semiconductor epitaxial wafer with suppressed surface waviness.

### BRIEF DESCRIPTION OF THE DRAWINGS

FIG. 1 is a schematic diagram of a surface of an indium phosphide substrate according to an embodiment of the present invention.
FIG. 2 is a schematic diagram of a wafer surface for explaining a method of calculating the waviness Wz.

### DETAILED DESCRIPTION OF THE INVENTION

Next, the embodiments of the present invention will be described in detail with reference to the drawings. It should be understood that the present invention is not limited to the following embodiments, and that appropriate changes and improvements in the design may be made based on the ordinary knowledge of those skilled in the art without departing from the spirit of the present invention.

### <Indium Phosphide Substrate >

The configuration of the indium phosphide substrate of this embodiment will be described below.

The indium phosphide (InP) substrate of this embodiment includes a substrate front surface (main surface), a substrate back surface, and an edge portion. The edge portion may have an orientation flat (OF) indicating the crystal orientation, and an index flat (IF) for distinguishing the main surface and the back surface of the substrate.

The main surface of the indium phosphide substrate can be a surface for forming an epitaxial crystal layer. The surface for forming an epitaxial crystal layer is a surface on which epitaxial growth is actually performed when the indium phosphide substrate of the present embodiment is used as a substrate for epitaxial growth to form a semiconductor device structure.

The main surface of the indium phosphide substrate is formed to have a diameter of 50 mm or more. The diameter of the main surface of the indium phosphide substrate may be 50 to 150 mm. The planar shape of the indium phosphide substrate may be circular or rectangular, such as a square.

The thickness of the indium phosphide substrate is not particularly limited, but is preferably, for example, 300 to 900 µm, and more preferably 300 to 700 µm. In particular, when the diameter (caliber) of the indium phosphide substrate is large, if the thickness of the indium phosphide substrate is less than 300 µm, there is a risk of cracking, and if it exceeds 900 µm, there may be a problem that the base crystal is wasted.

The indium phosphide substrate of the present embodiment may contain, as a dopant (impurity), Zn (zinc) so as to have a carrier concentration of 1×10¹⁶ cm⁻³ or more and 1×10¹⁹ cm⁻³ or less, S (sulfur) so as to have a carrier concentration of 1×10¹⁶ cm⁻³ or more and 1×10¹⁹ cm⁻³ or less, Sn (tin) so as to have a carrier concentration of 1×10¹⁶ cm⁻³ or more and 1×10¹⁹ cm⁻³ or less, or Fe (iron) so as to have a resistivity of 1×10⁶ Ω cm or more and 1×10³ Ω cm or less.

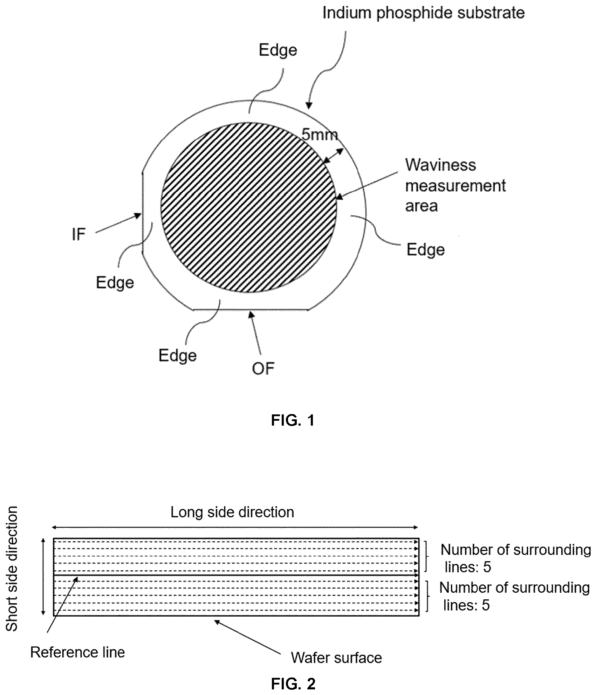

Fig. 1 shows a schematic diagram of the surface of an indium phosphide substrate according to an embodiment of the present invention. The indium phosphide substrate is formed in a substantially disk shape and has an OF and an IF. Note that Fig. 1 is a drawing for understanding the edge portion of the indium phosphide substrate according to an embodiment of the present invention, and the indium phosphide substrate according to an embodiment of the present invention is not limited to such a shape. In particular, it is not necessary to have an OF and an IF.

In the indium phosphide substrate according to the embodiment of the present invention, the waviness Wz of the entire substrate surface excluding the edge portion is controlled to 800 nm or less. Here, in the present invention, the area within approximately 5 mm from the outer periphery of the wafer to the center excluding the effects of roll-off is defined as the "edge portion", and the entire wafer surface excluding the area within 5 mm from the outer periphery of the wafer to the center excluding the effects of roll-off is defined as the "entire substrate surface excluding the edge portion". In other words, in the present invention, the "entire substrate surface excluding the edge portion" refers to the circular area in the center shown as the "waviness measurement area" in Figure 1.

Since the entire surface of the wafer is ground simultaneously, the measurement of the central portion excluding the edge portion (area within approximately 5 mm from the outer periphery to the center) where roll-off occurs due to the effects of polishing is used to measure the waviness of the entire wafer. In addition, since the waviness is periodic, it is considered to be constant regardless of the diameter.

In the present invention, the "waviness Wz" of the entire substrate surface excluding the edge portion is the "maximum waviness height" defined in JIS B 0601:2013. By measuring the waviness Wz, it is possible to quantify the average value of the waviness of the entire substrate surface excluding the edge portion.

The waviness Wz of the entire substrate surface excluding the edge portion of the indium phosphide substrate can be measured using the white light interference measurement function of a laser microscope VKX-3000 manufactured by Keyence Corporation. When measuring the waviness Wz of the entire substrate surface excluding the edge portion of the indium phosphide substrate, a 10x lens for interference measurement is used to measure the waviness (Wz: maximum waviness height) curve as a contour curve in a range of approximately 1 mm x 40 mm, with the center of the wafer being the center of the measurement range, and the waviness is calculated with a cutoff wavelength λc = 25 mm. In calculating the waviness Wz, as shown in Figure 2, the center of the short side of the substrate surface in an area of approximately 1 mm x 40 mm is used as a reference line, and 20 lines at intervals of approximately 4.5 µm (basic interval specified by the laser microscope VKX-3000) are used as one measurement interval (approximately 4.5 µm x 20 lines = approximately 90 µm intervals), and the waviness over 40 mm in the long side direction of 11 lines in total, including 10 surrounding lines moved parallel to the short side direction for the reference line and the reference line, is calculated, and the average value is taken as Wz. Note that this average value is automatically measured by the white light interference measurement function of the laser microscope VKX-3000 manufactured by Keyence Corporation.

The measurement is carried out in a clean room controlled at a room temperature of 22 ± 5°C so that the effects of thermal expansion, etc. can be ignored. Note that the various setting conditions for the white light interference measurement function of the laser microscope VKX-3000 are as follows.
- Tilt correction: Automatic
- DCL/BCL: None
- Measurement type: Waviness
- Cutoff wavelength: λs and λf are not set. λc is 25 mm.
- End effect correction: Enabled
- Double Gaussian: OFF
- Stylus mode: OFF
- Number of reference wavelengths: 1
- Number of profiles: 11

Since the entire surface of the wafer is ground simultaneously, there is no position dependency on the surface, and if the waviness curve of the above part is evaluated, it will be a representative measurement of the waviness of the entire wafer required for the bonding process. In addition, since the waviness is periodic, it is thought to be constant regardless of the aperture.

If the waviness Wz of the entire substrate surface excluding the edge portions of the indium phosphide substrate is 800 nm or less, the surface waviness after epitaxial growth is reduced, and an indium phosphide substrate can be provided in which poor adhesion due to the influence of waviness is well suppressed even when the indium phosphide substrate is bonded to a Si substrate including a Si device. The waviness Wz of the entire substrate surface excluding the edge portion of the indium phosphide substrate is preferably 700 nm or less, and more preferably 680 nm or less. In addition, the lower limit of the waviness Wz is not particularly limited, but Wz may be 500 to 800 nm.

### < Method of Manufacturing Indium Phosphide Substrate >

Next, a method of manufacturing an indium phosphide substrate according to an embodiment of the present invention will be described.

In the method of manufacturing an indium phosphide substrate, first, an ingot of indium phosphide is produced by a known method. Next, the indium phosphide ingot is ground to form a cylinder. At this time, an orientation flat (OF) and an index flat (IF) may be formed at predetermined positions on the outer periphery of the wafer.

Next, wafers having a main surface and a back surface are cut out from the ground indium phosphide ingot. At this time, both ends of the crystal of the indium phosphide ingot are cut along predetermined crystal planes using a wire saw or the like, and multiple wafers with a thickness of 750 to 850 µm are cut out.

In the process of cutting out the wafers, it is preferable to constantly feed new wire while reciprocating the wire horizontally, and to move the stage carrying the indium phosphide ingot vertically toward the wire.

The conditions for cutting the ingot with a wire saw are as follows:
- New wire feed speed: 10-60 m/min
- Wire reciprocating speed: 300-350 m/min
- Vertical movement speed of the stage carrying the ingot of indium phosphide: 200-400 µm/min
- Wire saw abrasive grain management:
   Abrasive grain GC #1200 and cutting oil PS-LP-500D are used, and the abrasive grain is managed so that the viscosity is 300-400 mPa·s when the rotor shaft of the viscometer rotates at 60 rpm. The viscosity can be measured with a TVB-10 viscometer manufactured by Toki Sangyo Co., Ltd.

Next, in order to remove the process-affected layer that occurs during the cutting process using the wire saw, the cut wafer is etched on both sides with a specified etching solution (primary etching). The wafer can be etched by immersing the entire wafer in the etching solution. As the etching solution, for example, a mixed solution of 85% by mass phosphoric acid aqueous solution and 30% by mass hydrogen peroxide solution is preferably used, and etching is preferably performed from both sides to a total depth of 5 to 15 µm.

Next, the outer periphery of the wafer is chamfered to a diameter of 50 mm or more. After the chamfering, both sides of the wafer are roughly polished. This rough polishing process is also called a lapping process, and is performed by polishing with a predetermined abrasive material to remove unevenness on the wafer surface while maintaining the flatness of the wafer. Here, in the above-mentioned cutting by wire saw, the entire wafer is undulated due to the wire vibration. The inventors have found that in order to remove this, it is necessary to remove the waviness by lapping after slicing (the process of cutting the wafer from the ingot). Specifically, it is necessary to remove a total thickness of 100 µm or more on the front and back sides of the wafer by lapping while applying a pressure of 100 g/cm² or more. In order to obtain a large amount of lapping, it is preferable to increase the thickness of the wafer during slicing as necessary.

Next, the wafer is etched on both sides with a predetermined etching solution (secondary etching). The wafer can be etched by immersing the entire wafer in the etching solution. As the etching solution, for example, a mixed solution of 85 mass% phosphoric acid aqueous solution, 30 mass% hydrogen peroxide solution, and ultrapure water is preferably used, and both sides are etched by a total of 7 to 15 µm.

Next, both sides of the wafer are polished. This process is a process for removing waviness that cannot be completely eliminated by the lapping process described above, and from the viewpoint of productivity, it is preferable to simultaneously polish both sides of multiple wafers. In order to uniformly eliminate waviness in all wafers polished simultaneously, when polishing both sides of the wafer with the upper and lower plates, it is necessary to supply sufficient polishing liquid to the wafer from multiple polishing liquid supply ports so that the polishing liquid is sufficiently permeated into the entire polishing pads provided on the upper and lower plates. Specifically, by supplying the polishing liquid at a flow rate of 0.07 mL/min·cm² or more per area of the upper or lower platen, uniform polishing of both sides of the wafer is possible. As a result, it is possible to remove waviness that cannot be completely eliminated by the lapping process. In this way, the waviness Wz of the entire substrate surface except for the edge portion can be controlled to 800 nm or less.

Next, the main surface of the wafer is polished with a mirror polishing abrasive to produce a mirror finish.

Next, cleaning is performed to produce an indium phosphide substrate according to an embodiment of the present invention. After the above-mentioned mirror finish, an indium phosphide substrate may also be produced by performing etching, mirror polishing, cleaning, etc.

### <Semiconductor Epitaxial Wafer>

By epitaxially growing a semiconductor thin film on the main surface of the indium phosphide substrate according to the embodiment of the present invention using a known method, an epitaxial crystal layer can be formed and a semiconductor epitaxial wafer can be produced. As an example of the epitaxial growth, a HEMT structure can be formed by epitaxially growing an InAlAs buffer layer, an InGaAs channel layer, an InAlAs spacer layer, and an InP electron supply layer on the main surface of the indium phosphide substrate. When producing a semiconductor epitaxial wafer having such a HEMT structure, a mirror-finished indium phosphide substrate is generally etched with an etching solution such as sulfuric acid/hydrogen peroxide to remove impurities such as silicon (Si) adhering to the substrate surface. After this etching process, the back surface of the indium phosphide substrate is supported by contacting it with a susceptor, and an epitaxial crystal layer is formed on the main surface of the indium phosphide substrate by molecular beam epitaxy (MBE) or metal organic chemical vapor deposition (MOCVD).

The semiconductor epitaxial wafer according to the embodiment of the present invention is manufactured using the indium phosphide substrate according to the embodiment of the present invention in which waviness over the entire substrate surface is suppressed as described above. Therefore, surface waviness after epitaxial growth is reduced, and even when the wafer is bonded onto a Si substrate including a Si device, poor adhesion due to the influence of waviness is effectively suppressed.

### EXAMPLES

The following examples of the present invention are provided for a better understanding of the present invention and its advantages, and are not intended to limit the invention.

### <Examples 1, 2>

Examples 1 and 2 were prepared as follows.

First, an indium phosphide ingot was prepared.

Next, the indium phosphide ingot was ground to form a cylinder. At this time, an orientation flat (OF) and an index flat (IF) were formed at predetermined positions on the outer periphery of the wafer.

Next, wafers having a main surface and a back surface were cut out from the ground indium phosphide ingot. At this time, both ends of the crystal of the indium phosphide ingot were cut along predetermined crystal planes using a wire saw or the like, and multiple wafers were cut out to a thickness of 0.84 mm.

In the process of cutting out the wafers, the wire was moved back and forth horizontally while new wire was constantly being fed, and the stage carrying the ingot of indium phosphide was moved vertically toward the wire.

The conditions for cutting the ingot with a wire saw are as follows:
- Wire feed speed: 10-60 m/min
- Wire reciprocating speed: 320 m/min
- Vertical movement speed of the stage carrying the ingot of indium phosphide: 330 µm/min
- Wire saw abrasive grain management:
   Abrasive grain GC #1200 and cutting oil PS-LP-500D were used, and the abrasive grain was managed to be 300-400 mPa·s when the rotor shaft of the viscometer rotated at a speed of 60 rpm. The viscosity can be measured using a TVB-10 viscometer manufactured by Toki Sangyo Co., Ltd.

Next, in order to remove the process-affected layer generated in the cutting process using the wire saw, the cut wafer was etched from both sides to a total depth of 15 µm using a mixed solution of 85% by mass phosphoric acid aqueous solution and 30% by mass hydrogen peroxide solution (primary etching). The wafer was etched by immersing the entire wafer in the etching solution.

Next, the outer periphery of the wafer was chamfered to a diameter of 50 mm or more. After the chamfering, both sides of the wafer were roughly polished (lapped). Specifically, a total thickness of 120 µm was removed from the front and back sides of the wafer by lapping while applying a pressure of 150 g/cm².

Next, the wafer was etched from both sides by a total of 7 µm using a mixed solution of 85% by mass phosphoric acid aqueous solution, 30% by mass hydrogen peroxide aqueous solution, and ultrapure water (secondary etching). The wafer was etched by immersing the entire wafer in the etching solution.

Next, both sides of the wafer were polished. This process is a process for removing waviness that cannot be completely removed by the lapping process. In this double-sided polishing process, when both sides of the wafer are polished with the upper and lower plates, a sufficient amount of polishing liquid was supplied to the wafer from multiple polishing liquid supply ports so that the polishing liquid would be sufficiently absorbed into the entire polishing pads provided on the upper and lower plates. Specifically, the polishing liquid was set to be supplied at a flow rate of 0.072 mL/min·cm² (total amount of polishing liquid) per area of the upper or lower plates. The areas of the upper and lower plates used were 5608 cm², respectively.

Next, the main surface of the wafer was polished with a mirror polishing abrasive to create a mirror finish.

The wafer was then cleaned to produce an indium phosphide substrate sample with a diameter of 76.2 mm and the shape shown in Figure 1.

### <Comparative Examples 1 to 5>

In each of Comparative Examples 1 to 5, a sample of an indium phosphide substrate having a diameter of 76.2 mm and a shape as shown in FIG. 1 was produced under the same conditions as in Examples 1 and 2, except that in the lapping step, a total thickness of 40 µm was removed from the front and back surfaces of the wafer by lapping, and in the double-sided polishing step after the secondary etching, the total amount of the polishing liquid described above was 0.065 mL/min cm².

### <Evaluation of Waviness Wz>

For the indium phosphide substrate samples of Examples 1 and 2 and Comparative Examples 1 to 5, the waviness Wz of the entire substrate surface excluding the edge portion was measured by the following method. That is, for each sample of the indium phosphide substrate with a diameter of 76.2 mm having IF and OF as shown in Figure 1 of Examples 1 and 2 and Comparative Examples 1 to 5, the area within approximately 5 mm from the outer periphery to the center was defined as the "edge portion", and the entire wafer surface excluding the area within 5 mm from the outer periphery to the center of the wafer excluding the influence of roll-off was defined as the "entire substrate surface excluding the edge portion".

Next, the waviness Wz of the waviness measurement area was measured using the white light interference measurement function of a laser microscope VKX-3000 manufactured by Keyence Corporation. For this measurement, a 10x lens for interference measurement was used to measure the waviness curve in an area of approximately 1 mm x 40 mm with the center of the wafer at the center of the measurement range, and the waviness was calculated with a cutoff wavelength λc of 25 mm. In calculating the waviness Wz, as shown in Figure 2, the center of the short side of the substrate surface in an area of approximately 1 mm x 40 mm was used as a reference line, and 20 lines with an interval of approximately 4.5 µm (basic interval specified by the laser microscope VKX-3000) were used as one measurement interval (approximately 4.5 µm x 20 lines = approximately 90 µm interval), and the waviness over 40 mm in the long side direction of 11 lines in total, including 10 surrounding lines moved parallel to the short side direction for the reference line and the reference line, was calculated, and the average value was taken as Wz. Note that this average value was automatically measured using the white light interference measurement function of the laser microscope VKX-3000 manufactured by Keyence Corporation.

The measurement was carried out in a clean room controlled at a room temperature of 22 ± 5°C so that the effects of thermal expansion, etc. could be ignored. Note that the various setting conditions for the white light interference measurement function of the laser microscope VKX-3000 were as follows.
- Tilt correction: Automatic
- DCL/BCL: None
- Measurement type: Waviness
- Cutoff wavelength: λs and λf are not set. λc is 25 mm.
- End effect correction: Enabled
- Double Gaussian: OFF
- Stylus mode: OFF
- Number of reference wavelengths: 1
- Number of profiles: 11

The manufacturing conditions and evaluation results mentioned above are shown in Table 1.

**[Table 1]**

| | diameter(mm) | total lapping amount of the front and back surfaces of the wafer(µm) | total polishing liquid amount (mL/min·cm²) | Wz(nm) |
|---|---|---|---|---|
| Ex. 1 | 76.2 | 120 | 0.072 | 572.7 |
| Ex.2 | 76.2 | 120 | 0.072 | 668.8 |
| Comp Ex.1 | 76.2 | 40 | 0.065 | 898.2 |
| Comp Ex.2 | 76.2 | 40 | 0.065 | 1018.9 |
| Comp Ex.3 | 76.2 | 40 | 0.065 | 1097.2 |
| Comp Ex.4 | 76.2 | 40 | 0.065 | 994.2 |
| Comp Ex.5 | 76.2 | 40 | 0.065 | 895.4 |

### <Discussion>

In both Examples 1 and 2, the waviness Wz of the entire substrate surface excluding the edge portion was 800 nm or less, and the surface waviness was well suppressed.

In contrast, in all of Comparative Examples 1 to 5, the waviness Wz of the entire substrate surface excluding the edge portion exceeded 800 nm.

Note that, in Examples 1 and 2, the total lapping amount of the front and back surfaces of the wafer was the same at 120 µm, and the total polishing liquid amount of the front and back surfaces of the wafer was also the same at 0.072 mL/min·cm², but the waviness Wz of the entire substrate surface excluding the edge portion was different values of 572.7 nm and 668.8 nm, respectively. Similarly, in Comparative Examples 1 to 5, the total lapping amount of the front and back surfaces of the wafer was the same at 40 µm, and the total polishing liquid amount of the front and back surfaces of the wafer was also the same at 0.065 mL/min·cm², but the waviness Wz of the entire substrate surface excluding the edge portion was different values between 895.4 and 1097.2 nm, respectively. This is believed to be because the waviness after cutting differs due to variations in temperature during cutting with the wire saw.

## Claims

1. An indium phosphide substrate, wherein
a diameter is 50 mm or more, and a waviness Wz of the entire substrate surface excluding the edge portion is 800 nm or less, and
the waviness Wz of the entire substrate surface excluding the edge portion is measured by the following steps (1) to (2):
(1) for an indium phosphide substrate, the area within 5 mm from the outer periphery to the center is defined as the edge portion, and the entire wafer surface excluding the area within 5 mm from the outer periphery to the center is defined as the entire substrate surface excluding the edge portion,
(2) next, the waviness Wz is measured using a white light interference measurement function of a laser microscope. In the measurement, a 10x lens for interference measurement is used to measure the waviness curve in a range of 1 mm x 40 mm with the center of the wafer being the center of the measurement range, and the waviness is calculated with a cutoff wavelength λc = 25 mm. In calculating the waviness Wz, the center of the short side direction on the substrate surface in a range of 1 mm x 40 mm is used as a reference line, and 20 lines with an interval of 4.5 µm are used as one measurement interval, and the waviness over 40 mm in the long side direction of 11 lines, including 10 surrounding lines moved parallel to the short side direction for the reference line and the reference line, is calculated, and the average value is used as the waviness Wz.

2. The indium phosphide substrate according to claim 1, wherein
the waviness Wz of the entire substrate surface excluding the edge portion is 500 to 800 nm.

3. The indium phosphide substrate according to claim 1 or 2, wherein
the diameter is 50 to 150 mm.

4. A semiconductor epitaxial wafer, comprising:
the indium phosphide substrate according to claim 1 or 2, and
an epitaxial crystal layer provided on the main surface of the indium phosphide substrate.

5. A semiconductor epitaxial wafer, comprising:
the indium phosphide substrate according to claim 3, and
an epitaxial crystal layer provided on the main surface of the indium phosphide substrate.
